# EUROPEAN PATENT APPLICATION

(11) **EP 1 544 874 A1**
(43) Date of publication of application: **22.06.2005**
(21) Application number: 03738141.5
(22) Date of filing: 02.07.2003
(51) Int. Cl.: H01F 10/32, H01L 43/08

(54) **SOLID MATERIAL COMPRISING A STRUCTURE OF ALMOST-COMPLETELY-POLARISED ELECTRONIC ORBITALS, METHOD OF OBTAINING SAME AND USE THEREOF IN ELECTRONICS AND NANOELECTRONICS**

(30) Priority: 19.07.2002 ES 200201701
(71) Applicant: CONSEJO SUPERIOR DE INVESTIGACIONES CIENTIFICAS, 28006 Madrid (ES)
(72) Inventor: GARCIA GARCIA, Nicolas, Insto. Tecnologias Fisicas, 28006 Madrid (ES)
(74) Representative: Ungria Lopez, Javier
(86) International application number: PCT/ES2003/000328
(87) International publication number: WO 2004/010442

(57) **Abstract**

The invention relates to a solid material which is **characterized in that** the electrons of the conduction band are almost completely polarised in the selected orbital. The invention also relates to the method of obtaining said material. The invention can be used to produce customised conductors, nanocontacts and contacts with a strict selection of resistance properties for the material thus formed. The invention further relates to the use of the inventive solid material in the development, manufacturing and production of devices including conductors, connectors, nanocontacts or contacts for the application thereof in the field of electronics and nanoelectronics.

## Description

### FIELD OF APPLICATION

Electronics, nanoelectronics and spintronics.

### BACKGROUND OF THE INVENTION

A 300% BMR was first discovered in 1999 by Garcia, Muñoz and Zhao of the Spanish Council for Scientific Research's Small Systems Physics and Nanotechnology Laboratory [1], in atom-to-atom contacts of a resistance in excess of 1000 Ohms and was explained as a result of the scattering of the ferromagnetic conduction electrons with very thin magnetic domain walls which were formed in the area of the nanocontact [2, 3]. It was later possible to obtain a revolutionary result by means of nanocontact electrodeposition procedures employing a resistance of very few Ohms using a "T"-shaped configuration for utilising magnetic anisotrophy, obtaining BMR of 700% in 2001 [4] which remained stable for days with the magnetic field cycle and which revealed the contacts to be lasting in industrial applications. Contrary to the case of the atom-to-atom contacts previously obtained in 1999, this new effect on the new contacts of (10-30 nm in cross-section) [5] cannot be explained by the scattering of the conduction electron spin on the domain walls [2, 3]. In 2002, experiments at the University of Buffalo using our "T"-shaped configuration and the same electrodeposition methods have obtained BMR of 3150% [6] advocating technical criteria such as the tapering of the elements comprising the nanocontact. Based on theoretical aspects taken into consideration, we had previously postulated [5,7] that, by creating a magnetically dead layer and modifying the status densities of the ferromagnetic materials comprising the nanocontacts, it should be possible to obtain indefinitely high BMR values tending, in fact, toward infinity when the filtering is total and the polarization of the conducting electrons is 1 (one) [2,3,5].

### DESCRIPTION OF THE INVENTION

### Brief Description

The invention relates to a solid material, referred to hereinbelow as the solid material of the invention, which is characterized in that the electrons of the conduction band are almost completely polarised in the selected orbital, and to the process of obtaining said material. The invention can be used to produce customised conductors, connectors, nanocontacts and contacts with a strict selection of resistance properties for the material thus formed. The invention further relates to the use of the solid material of the invention, in the development, manufacturing and production of devices including conductors, connectors, nanocontacts or contacts, for the application thereof in the field of electronics, nanoelectronics and spintronics.

### Detailed Description of the Invention

The invention is based on the inventors having found that resistance and/or, in particular, the BMR magnetoresistance of solid materials aimed to produce connectors, contacts, particularly nanocontacts, can be increased by several orders of magnitude by means of intelligent filtering processes, particularly electrochemical processes.

The BMR optimization process described herein is based on the use of leading theoretical principles which, when used for analyzing the level structure in the atom and/or molecular orbitals comprising the Fermi sea and the Fermi levels of the materials employed in nanocontacts, connectors and the conductors linked to them, afford the possibility of applying specific electrodeposition procedures for increasing the polarisation to the Fermi level by means of the generation of a dead magnetoresistant layer (dead magnetic layer).

These modifications make it possible to increase the resulting BMR thousands of times above the original values. As a result of the equation governing these effects, there is no limitation on the method employed as regards the maximum value of the BMR increase that is produced. In fact, if the value of the polarisation at the Fermi level nears a value of almost one, the resulting BMR can be raised to values tending toward infinite at the polarisation limit equalling 1. The dead magnetic layer serves two purposes, on one hand, to make the electron's spin scatter forcefully backward so as to retain the spin. In other words, that the electron spin in an electrode on one side of the nanocontact does not accommodate to the spin of the electron on the other side of the electrode, so when the configuration of the electrodes is antiferromagnetic, there will be no current between the electrodes, or the current will be much smaller than in the ferromagnetic configuration, producing a large BMR. The other purpose is that of filtering the unwanted electronic orbitals so that only the desired electronic orbitals will remain for the most part.

An object of the invention is a solid material, referred to hereinbelow as the inventive material, characterized in that the electrons of the conduction band are almost completely polarised or are of the desired polarisation in the selected orbital.

As used in the present invention, the term "solid material" refers to maters of defined electromagnetic properties, such as ferromagnetic materials, antiferromagnetic materials, ceramics, vitreous materials, silica compounds, organic or any other materials.

The term "almost-completely-polarised", as used in this invention, refers to the possibility of obtaining electron polarisation density values as near to 1 as desired.

As used in the invention, the term "selected orbital" refers to the electronic orbital of the electrons of the material wherein the spin polarisation is to be modified and adapted, in order to achieve the desired effect.

An object of the invention is also related to a process for obtaining the solid material of the invention characterised in that the techniques involved include the doping of the starting material with a chemical element, an organic compound or inorganic compound.

The characteristics of the nanocontacts, connectors and contacts will depend upon the chemical elements and organic or inorganic molecules which are selected for filtering the desired electronic orbitals in the conduction process between two electrodes connected to one another by any type of connector. The filtering is performed because the doping agents incorporated have the electrons and proper symmetries necessary for forming chemical bonds with the undesired electrons of the connecting materials in the conduction process. The elements and/or chemical compounds to perform the desired task, are selected according to the type of elements, the electrodes connecting the connector are comprised of.

A particular object of the invention is a Ni material with a sp-electrode filter obtained by means of electrodeposition with ClK as the chemical compound doped with Cl. This Ni material may likewise be doped with O, S, Br and F, instead of with Cl.

A final object of the invention is lastly related to the use of the solid material of the invention in the development, manufacturing and production of devices including conductors, nanocontacts or contacts for the application thereof in the field of electronics, nanoelectronics and spintronics.

### Bibliography:

1. N. Garcia, M. Muñoz and Y.-W. Zhao, Phys. Rev. Lett. 82, 2932 (1999).
2. G.G. Cabrera and L.M. Falicov, Phys. Status Solidi B 61, 539 (1974).
3. G. Tatara, Y - W. Zhao, M. Muñoz and N. Garcia, Phys. Rev. Lett. 83, 2030 (1999).
4. N. Garcia, M. Mumoz, G.G. Qian, H. Rohrer, I.G. Saveliev and Y.-W. Zhao, Appl. Phys. Lett 79, 4550 (2001).
5. N. Garcia, M. Muñoz, V.V. Osipov, E.V. Ponizovskaya, G.G. Qian, I.G. Saveliev and Y.-W. Zhao, J. Magn. Magn. Mater, 240, 92 (2002).
6. V.A. Molyneux, V.V. Osipov and E.V. Ponizovskaya, Phys. Rev. B 65, 184425 (2002).
7. Harsh Deep Chopra and Susan Z. Hua. Phys. Rev. B 66, 020403 (2002).

### BRIEF DESCRIPTION OF THE DRAWINGS

Figure 1 (a) Optical microscope view of the "T" contact end 1(b). The wires were electrochemically treated in KCl (see text). This process increases the BMR to very high values without depending upon any other parameter.
Figure 2. BMR cycle showing values of up to 4,014%.

### DESCRIPTION OF A PREFERRED EMBODIMENT OF THE INVENTION

### Example 1. Development of a Ni-Ni nanocontact by means of ClK electrodeposition

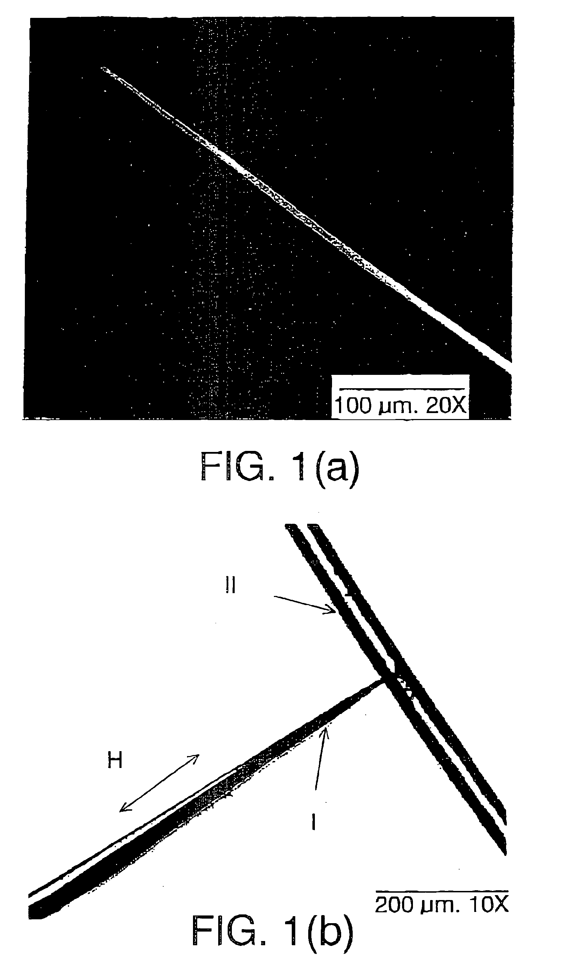

The experimental performing of the process object of this patent refers to Ni-Ni nanocontacts constructed by electrodeposition in a "T"-shaped configuration achieving a 4,000% BMR. Both end I as well as wiring II were electrochemically treated with ClK (Fig. 1), end I being 1,000 nm in size, thus making it possible to prove that the cause of the increase in the BMR is the electrochemical process and not the gauge of end I which is responsible for the increase in the BMR.

The Ni electrodes (wires) were mounted in a "T" configuration (Fig. 1). The field applied during the magnetoresistance measurements is in the direction of the connector marked "I" in Fig. 1, this structure, of our own design, being optimum for the magnetoresistance through the Ni nano-contact. The end of wire "I" in Fig. 1 was placed at a distance of a few microns up to ten microns from the Ni wire marked "II" in Fig. 1. prior to the electrodeposition on the Ni nano-contact. The Ni wiring (except in the area immediately following the nano-contact) was insulated with fast-drying epoxy resin to thus confine the deposition to the area between the wires. The electrodeposition of the nanocontact was carried out at room temperature. This deposition was performed by means of a saturated nickel sulphate (NiSO₄) electrolyte, (pH = 3.5). A -1.2V cathode power was used against a saturated calomel electrode. The deposition times are of less than 1 minute.

The magnetoresistance measurements were taken at room temperature in the presence of magnetic fields of up to H = 3,000 Oe for the configuration (current-in-plane)/(field-in-plane) (CIP/FIP).

The "I" end was constructed according to the following development manufacturing process. First, one end was constructed by mechanical breaking of a 125 µm Ni wire. By electrolytic techniques, the gauge was reduced to values within the 600 nm to 1,000 nm range. The Ni end was inserted into a cell filled with KCl 2M, and a constant 2V voltage was applied (Fig. 1a). The reduction in the gauge took place in accordance with the anodic reaction Ni(s) + 2Cl⁻ =NiCl₂ +2e-, the Pt cathode reaction being 2H₂O + 2e- = H₂ + 20H. The BMR increase is due to the treatment, with KCl in this example.

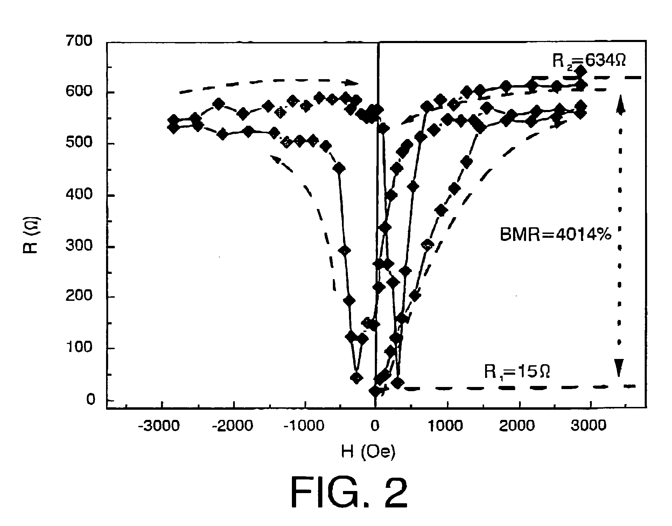

Fig. 2 shows the consecutive magneto-resistance cycles in a sample for which the starting zero field contact resistance value was 15 following the electrodeposition. This contact resistance "R" determines the diameter d = 100/R ( ) (in nm) of the nano-contact. In this sample, this diameter is 8 nm. Fig. 2 shows how the resistance of the sample increases rapidly when the field intensity increases. In saturation condition, the resistance rises to 634 , remaining essentially unchanged as compared to subsequent increases in the value of the filed. This means a 4,014% increase in the BMR at room temperature in a field of approximately 1,000 Oe. The peak on the BMR curve corresponds to a field value of 280 Oe.

## Claims

1. Solid material **characterized in that** the electrodes of the conduction band are of the desired spin polarisation, being able to be almost completely polarised in the selected orbital.

2. Solid material according to claim 1 **characterized in that** it is one of those pertaining to the following group: ferromagnetic materials, antiferromagnetic materials, ceramics, vitreous materials and silicon dioxide compounds or any other type of compounds.

3. Process for obtaining solid material according to claims 1 and 2, **characterized in that** it comprises doping the conductors and/or contacts, connectors or nanocontacts with a chemical element or organic or inorganic compound.

4. Solid material according to claims 1 and 2,
**characterised in that** it is Ni, and the doping process according to claim 3 hereinabove is performed by electrodeposition with C1K.

5. Solid material according to claim 4, **characterised in that** chemical compounds comprising elements such as O, S, Br or F or any other type of organic or inorganic molecule are used instead of ClK.

6. Use of solid material according to claims 1, 2, 4 and 5 in the development, manufacturing and production of devices including conductors, connectors, nanocontacts or contacts for the use thereof in the filed of electronics, nanoelectronics or spintronics.
